# EUROPEAN PATENT APPLICATION

(11) **EP 0 962 780 A2**
(43) Date of publication of application: **08.12.1999**
(21) Application number: 99304274.6
(22) Date of filing: 02.06.1999
(51) Int. Cl.: G01R 13/02

(54) **Bar graph display for ac user interface**

(30) Priority: 03.06.1998 US 89643
(71) Applicant: ONAN CORPORATION, Minneapolis, MN 55432 (US)
(72) Inventor: Middleton, Paul L., Blaine, Minnesota 55434 (US); Loisel, Jean-Marie, Coon Rapids, Minnesota 55448 (US)
(74) Representative: Beresford, Keith Denis Lewis

(57) **Abstract**

A display panel for displaying AC electrical data and a method of displaying are disclosed. The display panel includes a display with a plurality of bar graphs, collocated and aligned. The bar graphs may display a single AC characteristic for different phases, or different AC characteristics for a phase or group of phases. The AC characteristics may include voltage, current, frequency, real power, apparent power, reactive power and power factor. The bar graphs, aligned and collocated, provide easier determination of relationship between AC characteristics. The display and method may have the capability of displaying fluctuational extremes of the AC characteristics simultaneously with present values thereof.

## Description

### Background of the Invention

The present invention relates to a method and apparatus for displaying AC operational information.

Alternating current (AC) power is used in a multitude of applications, and it is virtually always desirable or necessary for an operator to monitor the AC during operation, for example using a display. Applications for such displays include, but are not limited to, generator sets including a generator and an engine, transfer switches, etc.

During operation of, for example, a generator set it is desirable to display operational information so the operator/user can monitor the operational status of the generator. Traditionally this has been done by the use of rotating analog meters. One meter might be used with a selector switch used to switch between the three phases of the generator. Alternatively, three separate meters might be used to display the various operational data for each phase. In some cases this is accomplished by the use of alphanumeric displays with a menu selection.

The present invention provides a novel method and apparatus for displaying AC operational information which allows the overall operational status of the electric device to be more quickly comprehended than traditional methods and apparatus for displaying AC operational information.

### Summary of the Invention

The present invention relates to a method and apparatus for displaying AC operational information.

The apparatus is a display panel connected to an electrical device for displaying AC characteristics. The display panel includes a display with a plurality of bar graphs, collocated and aligned.

In one embodiment, the display includes three current bar graphs arranged next to each other. Each current bar graph displays one phase current of the electrical device, and the three current bar graphs are scaled identically in percent of a maximum current at which the electrical device is capable of operating. A preferred embodiment further includes means for displaying fluctuation extremes of the phase currents, simultaneously with present values thereof.

In another embodiment, the display panel includes three voltage bar graphs arranged next to each other for displaying phase voltages and one frequency bar graph nearby for displaying a frequency of the electrical device. The voltage and frequency bar graphs are scaled identically in percent of nominal value, with percentages extending above and below the nominal value. A preferred embodiment further includes means for displaying fluctuation extremes of the phase voltages and frequency, simultaneously with present values thereof.

In yet another embodiment, the display panel includes two power bar graphs arranged next to each other for displaying AC characteristics selected from the group consisting of real power, apparent power, reactive power and power factor.

In yet another embodiment of the invention, the display panel includes all three sets of bar graphs displays so as to provide the operator with a readily comprehensible operational status of the electrical device.

The method according to the invention comprises providing a plurality of collocated and aligned bar graphs, and displaying AC characteristics on the bar graphs.

Embodiments of the method may include displaying phase currents of the electrical device, displaying phase voltages and frequency of the electrical device, and displaying various power outputs of the electrical device.

Using the invented apparatus and method is advantageous because by observing bar graphs displaying AC data, the operator can instantly obtain accurate information on the magnitude of the AC data in each phase and the balance between the phase data. Embodiments of the invention include the further advantage that fluctuational extremes of the AC characteristics may be observed simultaneously with present values.

These and various other advantages and features of novelty which characterize the present invention are pointed out with particularity in the claims annexed hereto and forming a part hereof. However, for a better understanding of the present invention, its advantages, and other objects obtained by its use, reference should be made to the drawings which form a further part hereof, and to the accompanying descriptive matter, in which preferred embodiments of the present invention are illustrated and described.

### Brief Description of the Drawings

Referring now to the drawings wherein like reference numerals generally indicate corresponding parts throughout the several views,
Figure 1 is a diagrammatic perspective view of an embodiment of a display generally in accordance with the principles of the present invention for displaying the magnitude of current in each phase, the balance of phase currents, and the maximum current in each phase at which the electrical device is capable of operating;
Figure 2 is a diagrammatic perspective view of an embodiment of a display generally in accordance with the principles of the present invention for displaying the magnitude of voltage in each phase, the balance of the phase voltages, the frequency of the electrical device, the relationship of frequency to voltage;
Figure 3 is a diagrammatic perspective view of an embodiment of a display generally in accordance with the principles of the present invention for displaying real power output, real power capability, apparent power output, and apparent power capability; and
Figure 4 is a planar view of an embodiment of a generator set display generally in accordance with the principles of the present invention wherein the generator control panel includes all three set of bar graphs displays shown in figures 1-3.

### Detailed Description of Preferred Embodiments of the Invention

Embodiments of the present invention are used together with alternating currents (AC). Such currents have many properties or characteristics, both electrical and mechanical. AC may be single-phase or multi-phase, and the invention may be used with both of these kinds of AC. It is noted that AC characteristics in a multi-phase embodiment may be displayed and presented both with respect to an individual phase and as a composite of multiple phases. Also, bar graphs next to each other on the display may show the same AC characteristic for different phases, or they may show different AC characteristics for one phase or group of phases (in a single-phase or multi-phase system), or they may show different AC characteristics for different phases, if desired.

Referring now to the figures there is illustrated a preferred embodiment of method and apparatus for displaying AC operational information generally in accordance with the principles of the present invention.

The AC characteristics displayed with embodiments of the invention may include voltage, current, frequency, real power, apparent power, reactive power and power factor. These are all well-known electrical characteristics, some or all of which may be necessary to monitor in a particular application. The display panel will be connected to the electrical device in a suitable way for displaying the desired AC characteristics.

As noted above, AC characteristics are present in a variety of applications using electrical devices. One application for a display panel is the monitoring of AC data from a generator set. Another application is a transfer switch, where AC information needs to be monitored.

AC data can be displayed with a plurality of display means. Bar graphs, as used in this application, typically include an elongated graph which can be illuminated or otherwise visibly activated completely or partially, to indicate to the operator the value of a particular characteristic. For example, a bar graph may include a number of LED:s positioned in an elongated configuration, whereby the value is displayed. In this example, the value may be displayed by illuminating all LED:s from one end of the bar graph to the one LED corresponding to the present value, or only the one LED corresponding to the present value may be displayed. Other kinds of bar graphs are also useable, such as a series of lamps or an LCD display.

Embodiments may be provided with the capability to display fluctuation extremes of the AC characteristics, simultaneously with present values thereof. For example, when the bar graph includes a number of LEDs, an LED corresponding to the extreme value may remain lit for a period after the value occurred. Similar features may be provided when the bar graph consists of a number of lamps or of an LCD display. In addition to remaining lit for a period of time, the LED (or equivalent) may be distinguished by altering its appearance, for example by making it brighter than the rest of the bar graph, or less bright, or by flashing the LED on and off. As another alternative, an alphanumeric display may be provided, which presents the fluctuation extremes of the AC characteristics.

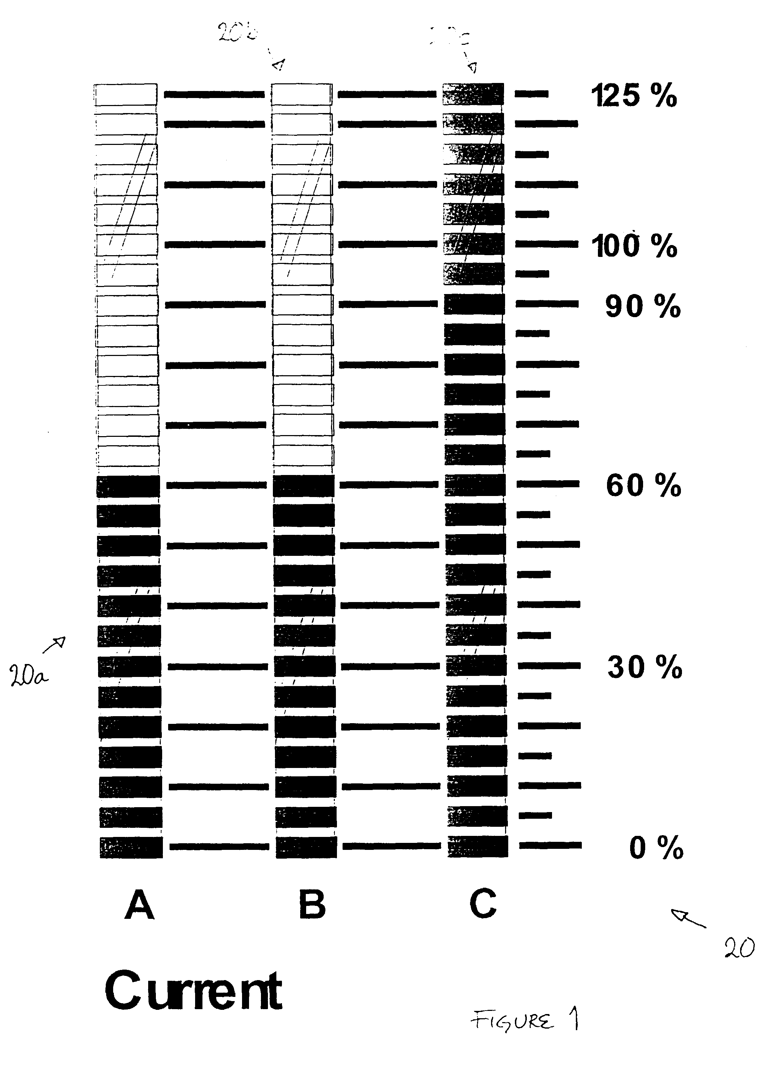

In Figure 1 there is illustrated an embodiment of a display 20 for displaying simultaneously the magnitude of current in each phase, the balance of phase currents, and the maximum current in each phase at which the electrical device is capable of operating.

In the embodiment shown in Figure 1, the display 20 includes three vertically oriented bar graphs 20a-c arranged next to each other with all three bar graphs being scaled identically in percent of the maximum current at which the electrical device is capable of operating. The height of the illuminated portion of each bar graph gives an instant visual indication of how close the current is to the device's limit. Colors may be used, such as green, yellow, red, to reinforce the visual indication, and in particular to indicate the proximity of the AC characteristic to operating limits of the electrical device. Differences in the heights of the illuminated portion of each bar graph also provides an indication of the presence and magnitude of phase imbalances. In bar graphs 20a and 20b the current in phases A and B is shown to be at about 65% of the maximum. In bar graph 20c the current in phase C is shown to be at least 125% of the maximum current.

In one embodiment, the bar graphs 20a-c might utilize a peak detect function by leaving on the highest valued lamp illuminated for a period of time after the detected value decreases. This allows the user some time to see the maximum on all three graphs for some time after a load transient.

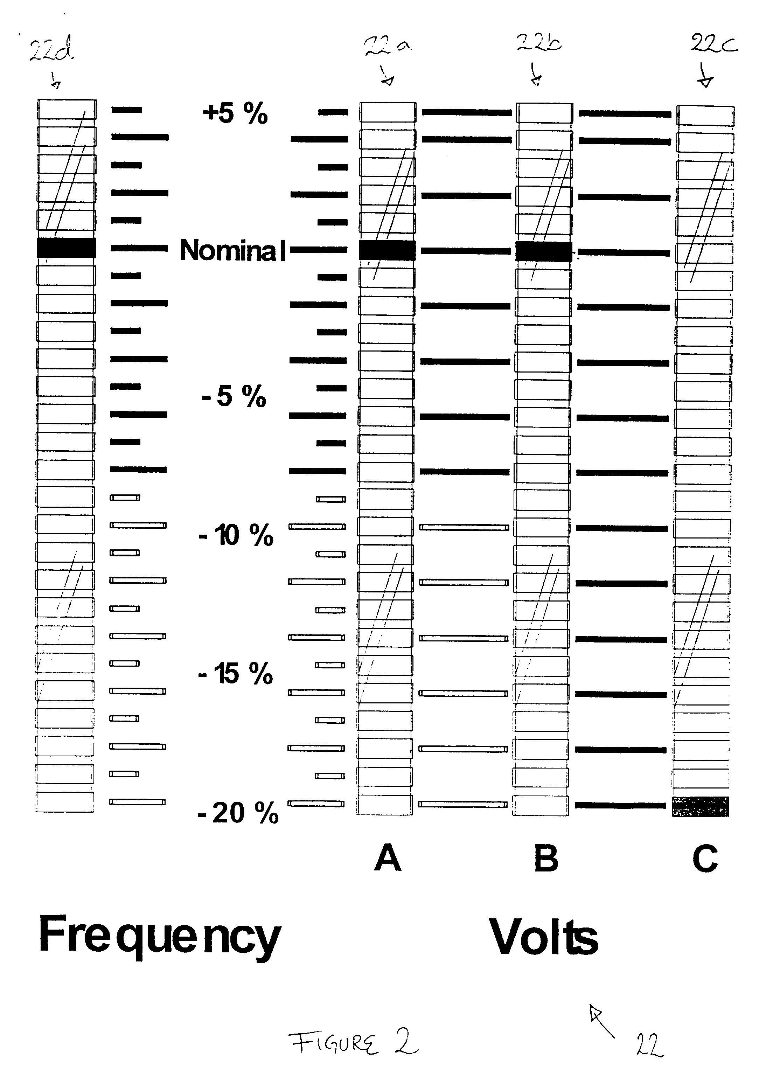

In Figure 2 there is illustrated an embodiment of a display 22 for displaying simultaneously the magnitude of voltage in each phase, the balance of the phase voltages, the frequency of the electrical device, and the relationship or "correctness" of frequency and voltage. In this embodiment, the minimum voltage and frequency experienced during a load transient is also displayed.

In the embodiment shown in Figure 2, the display 22 includes three bar graphs 22a-c, arranged next to each other with a fourth bar graph 22d nearby. All four bar graphs 22a-d are scaled identically in percent of nominal value, with some percentages extending above and below the nominal. During normal operation, each of the graphs will be at the nominal value. Any deviation from the nominal value which persists will indicate a fault condition. These bar graphs preferably operate in the "dot" mode with only the current lamp value lit, rather than illuminating all the lamps below the current value. In the shown embodiment, the phase voltage in bar graphs 22a and 22b is shown to be at its nominal value. The phase voltage in bar graph 22c is shown at the lowest voltage value that may be displayed. This indicates that the phase voltage is at the lowest displayable value, or below that value.

In one embodiment, the lamp of each of the bar graphs 22a-d which represents the nominal value might be color coded with green indicating normal values while those lamps indicating values above and below nominal might be color coded yellow so as to indicate a potentially bad condition.

In another embodiment, the bar graphs 22a-d might utilize a peak detect function by leaving on the lowest or highest valued lamp illuminated for a period of time after the detected value changes. This allows the user some time to see the minimums or maximums on all four graphs for some time after a transient.

In yet another embodiment, the bar graphs 22a-c may be provided without the fourth bar graph 22d.

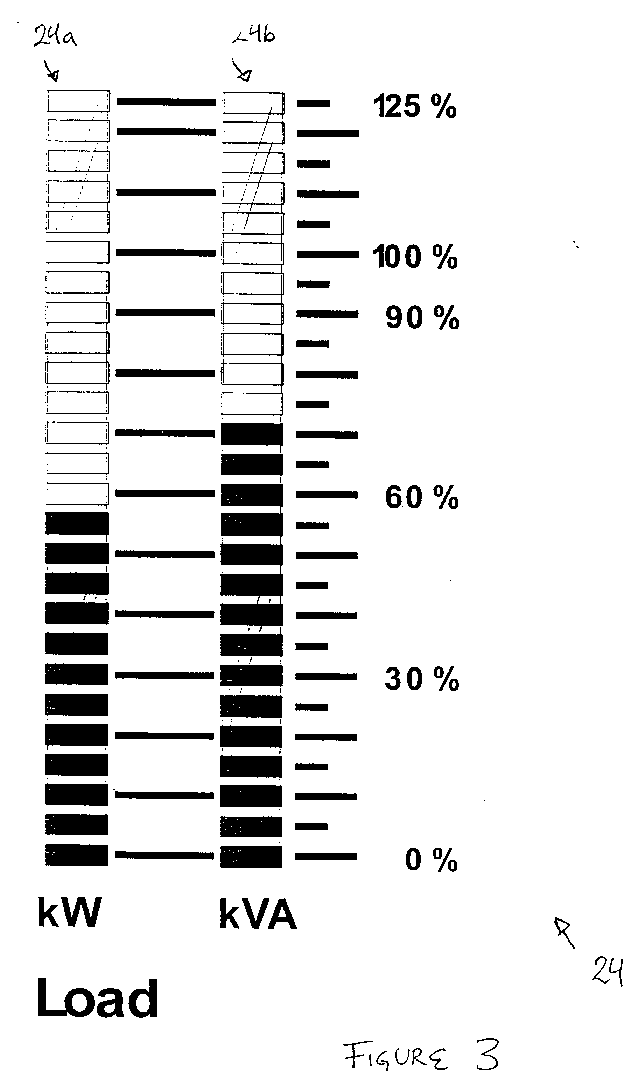

In Figure 3 there is illustrated an embodiment of a display 24 for displaying real power output, real power capability, apparent power output and apparent power capability.

Several AC characteristics related to power may be displayed, such as real power, apparent power, reactive power and power factor. Power factor is the ratio between real and apparent power. Typically the bar graph will be graded in a unit corresponding to the particular power AC characteristics. For example, real power may be measured in kilowatts (kW), apparent power may be measured in kVA, reactive power may be measured in kVAR.

In the embodiment shown in Figure 3, the display 24 includes two bar graphs 24 a,b arranged next to each other and scaled as a percentage of maximum capability, one displaying kW and the other displaying kVA. The height of the illuminated portion of each of the bar graphs gives an instant visual indication of how close the power is to the limit. Colors (green, yellow, red) may be used to further enhance the visual indication. Differences in the heights of the illuminated portions of the bar graphs further provide an instantaneous indication of the power factor. The power is shown to be at 55% of the maximum kW output, and at 70% of the maximum kVA output.

Although bar graphs for real and apparent power are shown in Figure 3, it is noted that it is possible to display any combination of AC characteristics on the bar graphs. For example, the bar graphs may display AC characteristics such as real power, apparent power, reactive power and power factor.

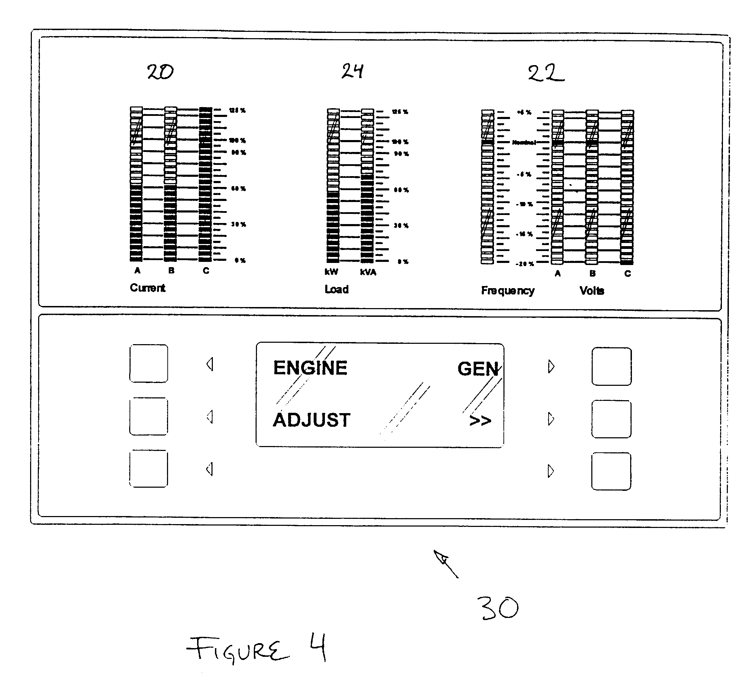

In Figure 4 there is illustrated an embodiment of a generator control panel 30, which includes all three sets of the bar graph displays 20, 22, and 24 so as to provide the operator with a readily comprehensible operational status of the generator.

Obtaining information from bar graphs placed next to each other gives an instant and virtually effortless interpretation of the relation between related values displayed on different graphs. By glancing quickly at, for example, three bar graphs each displaying a phase current, the operator can immediately obtain essential information in the following way. In viewing the current levels the operator easily determines if any current reaches or exceeds the maximum value, as indicated on each bar graph. At the same time, the operator can instantly obtain an accurate indication of the balance between the three currents, because the bar graphs are placed next to each other and have identical scaling. Optional peak detection functions and modes of displaying a value further provide very quick and reliable information access in real time. These and other advantages arise with equal magnitude in other applications of the invention, such as when it is used to display phase voltages, for example.

It is to be understood that even though numerous characteristics and advantages of the present invention have been set forth in the foregoing description, together with details of the structure and function of the invention, the disclosure contained herein is illustrative, and changes in matters of order, shape, size and arrangement of parts and of steps may be made within the principles of the present invention and to the full extent indicated by the broad general meaning of the terms in which the appended claims are expressed.

## Claims

1. A display panel for displaying AC characteristics for an electrical device, the display panel comprising a display with a plurality of collocated and aligned bar graphs.

2. The display panel of claim 1, wherein the bar graphs are adapted to display the same AC characteristic, each for a different phase of a multiphase AC device.

3. The display panel of claim 2, wherein the AC characteristics are selected from a group consisting of current, voltage, real power, apparent power, reactive power and power factor.

4. The display panel of claim 3, including three current bar graphs arranged next to each other, each one of the three current bar graphs displaying a respective one phase current of the electrical device, the three current bar graphs being scaled identically in percent of a maximum current at which the electrical device is capable of operating.

5. The display panel of claim 1, including three voltage bar graphs arranged next to each other for displaying respective phase voltages and one frequency bar graph for displaying a frequency of the electrical device, the voltage and frequency bar graphs being scaled identically in percent of nominal value, with percentages extending above and below the nominal value.

6. The display panel of claim 2, including three voltage bar graphs arranged next to each other for displaying phase voltages, the voltage bar graphs being scaled identically in percent of nominal value, with percentages extending above and below the nominal value.

7. The display panel of claim 1, including at least two power bar graphs arranged next to each other for displaying the AC characteristics, wherein the AC characteristics are selected from a group consisting of real power, apparent power, reactive power and power factor.

8. The display panel of claim 1, further including means for displaying fluctuation extremes of the AC characteristics simultaneously with present values thereof.

9. The display panel of claim 1, wherein at least one bar graph displays the AC characteristics using color to indicate a proximity of the AC characteristics to operating limits of the electrical device.

10. A display panel for displaying AC characteristics for an electrical device, comprising:
display apparatus for displaying phase currents and adapted to display simultaneously a magnitude of current in each phase, a balance of the phase currents, and a maximum current in each phase at which the electrical device is capable of operating;
display apparatus for displaying phase voltages and frequency and adapted to display simultaneously a magnitude of voltage in each phase, a balance of the phase voltages, a frequency of the electric device, and a relationship of frequency to voltage; and
display apparatus adapted to display simultaneously real power output, real power capability, power factor output, and power factor capability.

11. A method of displaying AC electrical data from an electrical device, the method comprising:
providing a plurality of collocated and aligned bar graphs; and
displaying AC characteristics on the bar graphs.

12. The method of claim 11, including displaying respective currents of the electrical device on the bar graphs, and scaling the bar graphs identically in percent of a maximum current at which the electrical device is capable of operating.

13. The method of claim 11, further including displaying on the bar graphs fluctuation extremes of the AC characteristics simultaneously with present values thereof.

14. The method of claim 11, including displaying phase voltages of the electrical device on the bar graphs, and scaling the bar graphs identically in percent of nominal value, with percentages extending above and below the nominal value.

15. The method of claim 14, further including displaying a frequency of the electrical device on the bar graphs.

16. The method of claim 11, including displaying respective power outputs of the electrical device on the bar graphs, and scaling the bar graphs identically in percent of nominal value, with percentages extending above and below the nominal value.

17. The method of claim 11, wherein displaying the AC characteristics includes activating only portions of the bar graphs corresponding to present values of the AC characteristics.

18. A method of displaying multi-phase AC electrical data from an electrical device on collocated and aligned bar graphs, the method comprising the steps of:
providing a display of phase currents which displays simultaneously a magnitude of current in each phase, a balance of the phase currents, and a maximum current in each phase at which the electrical device is capable of operating;
providing a display of phase voltages and frequency which displays simultaneously a magnitude of voltage in each phase, a balance of the phase voltages, a frequency of the electrical device, and a relationship of frequency to phase voltage; and
providing a display of power which simultaneously displays real power output, real power capability, power factor output, and power factor capability.

19. An AC electrical device including a display for displaying electrical data associated with respective phases of the AC by means of colocated and aligned bar graph indicators.
